# EUROPÄISCHE PATENTSCHRIFT

(11) **EP 2 606 510 B1**
(45) Veröffentlichungstag und Bekanntmachung des Hinweises auf die Patenterteilung: **03.05.2017**
(21) Anmeldenummer: 11752144.3
(22) Anmeldetag: 12.08.2011
(51) Int. Cl.: H01L 21/768, H01L 33/62, H01L 33/50, H01L 33/00, H01L 33/48

(54) **VERFAHREN ZUR HERSTELLUNG ZUMINDEST EINES OPTOELEKTRONISCHEN HALBLEITERBAUELEMENTS**
METHOD FOR PRODUCING AT LEAST ONE OPTOELECTRONIC SEMICONDUCTOR COMPONENT
PROCÉDÉ DE FABRICATION D'AU MOINS UN COMPOSANT SEMI-CONDUCTEUR OPTOÉLECTRONIQUE

(30) Priorität: 17.08.2010 DE 102010034565
(43) Veröffentlichungstag der Anmeldung: 26.06.2013
(73) Patentinhaber: OSRAM Opto Semiconductors GmbH, 93055 Regensburg (DE)
(72) Erfinder: WEIDNER, Karl, 81245 München (DE); WULKESCH, Hans, 81739 München (DE); KALTENBACHER, Axel, 93098 Mintraching (DE); WEGLEITER, Walter, 93152 Nittendorf (DE); RAMCHEN, Johann, 83233 Bernau am Chiemsee (DE)
(74) Vertreter: Epping - Hermann - Fischer
(86) Internationale Anmeldenummer: PCT/EP2011/063987
(87) Internationale Veröffentlichungsnummer: WO 2012/022695

(56) Entgegenhaltungen:
- WO-A1-2012/010377
- WO-A1-2012/020062
- WO-A2-2006/005062
- DE-A1-102007 029 369
- US-A1- 2002 182 845
- US-A1- 2009 267 108
- US-A1- 2010 117 530

## Beschreibung

Es wird ein Verfahren zur Herstellung zumindest eines optoelektronischen Halbleiterbauelements angegeben.

Eine zu lösende Aufgabe besteht darin, ein Verfahren zur Herstellung eines optoelektronischen Halbleiterbauelements anzugeben, welches kostengünstig ist.

Das Dokument US 2010/0117530 A1 beschreibt ein LED-Bauelement und ein Verfahren zu dessen Herstellung.

Das Dokument US 2002/182845 A1 beschreibt ein Verfahren zur Herstellung eines Halbleiterbauteils.

Das Dokument WO 2012/010377 A1 beschreibt ein optoelektronisches Bauteil und ein Verfahren zu dessen Herstellung.

Das Dokument WO 2012/020062 A1 beschreibt ein optoelektronisches Bauelement und ein Verfahren zu dessen Herstellung.

Die Erfindung betrifft ein Verfahren gemäß Anspruch 1.

Gemäß zumindest einer Ausführungsform des Verfahrens wird in einem ersten Schritt ein Träger bereitgestellt, der eine Oberseite und eine der Oberseite des Trägers gegenüberliegende Unterseite aufweist. Bei dem Träger kann es sich um eine Leiterplatte oder einen metallischen Trägerrahmen (Leadframe) handeln. Ebenso ist denkbar, dass der Träger flexibel und beispielsweise als eine Folie ausgebildet ist. Der Träger kann mit einem elektrisch leitenden Material, beispielsweise einem Metall und/oder einem elektrisch isolierenden Material, beispielsweise einem duro- oder thermoplastischen Material und/oder auch einem keramischen Material, gebildet sein.

An der Oberseite und der Unterseite ist jeweils eine Fläche ausgebildet, die durch einen Teil der Außenfläche des Trägers gebildet ist. Die Fläche an der Unterseite ist der Teil der Außenflächen des Trägers, die einem Kontaktträger - beispielsweise eine Leiterplatte - im montierten Zustand des Trägers zugewandt ist.

Zum Beispiel ist die Fläche an der Unterseite des Trägers eine Montagefläche, die zur Montage des späteren Halbleiterbauelements auf dem Kontaktträger dienen kann. Ferner weist der Träger eine Mehrzahl von in lateraler Richtung nebeneinander an der Oberseite angeordneten Anschlussflächen auf. In "lateraler Richtung" bedeutet in diesem Zusammenhang, eine Richtung parallel zur Haupterstreckungsrichtung des Trägers. "Nebeneinander" bedeutet, dass die Anschlussstellen in lateraler Richtung beabstandet zueinander angeordnet sind.

Gemäß zumindest einer Ausführungsform des Verfahrens wird in einem nächsten Schritt eine Mehrzahl von in lateraler Richtung beabstandet zueinander angeordneter optoelektronischer Bauelemente an der Oberseite des Trägers aufgebracht. Die optoelektronischen Bauelemente weisen jeweils zumindest eine dem Träger abgewandte Kontaktfläche auf. Beispielsweise sind in lateraler Richtung Zwischenräume zwischen den einzelnen optoelektronischen Bauelementen vorhanden. In einer Draufsicht auf den Träger sind die Zwischenräume durch Seitenflächen zweier jeweils aneinander angrenzender optoelektronischer Bauelemente und der den Bauelementen zugewandten Montagefläche des Trägers begrenzt. Die zumindest eine Kontaktfläche dient zur elektrischen Kontaktierung des optoelektronischen Halbleiterbauelements und ist mit einem elektrisch leitfähigen Material, beispielsweise einem Metall, gebildet. Vorzugsweise ist jeder Kontaktfläche eines optoelektronischen Bauelements eine Anschlussfläche des Trägers eindeutig oder eineindeutig zugeordnet. Zum Beispiel sind die Anschlussflächen und die optoelektronischen Bauelemente in lateraler Richtung nebeneinander angeordnet. Mit anderen Worten benachbart sich jeweils eine Anschlussfläche mit einer ihr zugeordneten Kontaktfläche des optoelektronischen Bauelements. Beispielsweise ist das optoelektronische Bauelement mit einer der Kontaktfläche abgewandten Außenfläche auf einer Kontaktstelle des Trägers gebondet, gelötet oder elektrisch leitend geklebt. Bei dem optoelektronischen Bauelement kann es sich um einen strahlungsempfangenden oder um einen strahlungsemittierenden Halbleiterchip handeln. Beispielsweise handelt es sich bei dem Halbleiterchip um einen Lumineszenzdiodenchip. Bei dem Lumineszenzdiodenchip kann es sich um einen Leuchtdiodenchip oder um einen Laserdiodenchip handeln.

Gemäß zumindest einer Ausführungsform des Verfahrens werden in einem nächsten Schritt Schutzelemente auf die Kontaktflächen und die Anschlussflächen aufgebracht. Das heißt, dass die Schutzelemente zumindest stellenweise in direktem Kontakt mit den Anschlussflächen und den Kontaktflächen stehen. In einer Draufsicht auf den Träger überlappen die Schutzelemente in vertikaler Richtung zumindest stellenweise mit den Kontaktflächen und den Anschlussflächen. "Vertikale Richtung" bezeichnet dabei eine Richtung senkrecht zur lateralen Richtung.

Gemäß zumindest einer Ausführungsform des Verfahrens wird in einem nächsten Schritt zumindest eine elektrisch isolierende Schicht auf freiliegende Stellen des Trägers, der Kontaktflächen sowie der Schutzelemente aufgebracht. Vorzugsweise bildet sich zwischen der elektrisch isolierenden Schicht und den freiliegenden Stellen des Trägers, der Kontaktflächen sowie den Schutzelementen weder ein Spalt noch eine Unterbrechung aus.

Gemäß zumindest einer Ausführungsform des Verfahrens werden in einem nächsten Schritt die Schutzelemente entfernt, wodurch Öffnungen in der elektrisch isolierenden Schicht erzeugt werden. Die Öffnungen erstrecken sich jeweils in vertikaler Richtung vollständig durch die elektrisch isolierende Schicht hindurch. Beispielsweise weisen die Öffnungen zumindest eine Seitenfläche auf. Die zumindest eine Seitenfläche der Öffnung ist zumindest stellenweise durch die elektrisch isolierende Schicht gebildet.

Gemäß zumindest einer Ausführungsform des Verfahrens wird in einem nächsten Schritt elektrisch leitfähiges Material auf der elektrisch isolierenden Schicht und zumindest stellenweise in den Öffnungen angeordnet, wobei das elektrisch leitfähige Material jeweils eine Kontaktfläche mit der ihr zugeordneten Anschlussfläche elektrisch leitend verbindet. Das heißt, das elektrisch leitfähige Material verbindet jeweils elektrisch leitend ein optoelektronisches Bauelement mit einer dem Bauelement zugeordneten Anschlussfläche des Trägers und verläuft dabei zwischen dem optoelektronischen Bauelement und der Anschlussfläche zumindest stellenweise an einer dem Träger abgewandten Oberseite der elektrisch isolierenden Schicht. Das elektrisch leitfähige Material kann dabei stellenweise direkt auf einer Außenfläche der elektrisch isolierenden Schicht angeordnet sein. Zum Beispiel ist das elektrisch leitfähige Material mit einem Metall oder einem elektrisch leitfähigen Klebstoff gebildet. Vorzugsweise ist eine elektrisch leitende Verbindung zwischen einem optoelektronischen Bauelement und einer dem optoelektronischen Bauelement zugeordneten Anschlussfläche des Trägers vollständig durch das elektrisch leitfähige Material gebildet. Beispielsweise sind die Öffnungen vollständig mit dem elektrisch leitfähigen Material ausgefüllt.

Gemäß zumindest einer Ausführungsform des Verfahrens wird in einem ersten Schritt ein Träger bereitgestellt, der eine Oberseite, eine der Oberseite des Trägers gegenüberliegende Unterseite, sowie eine Mehrzahl von in lateraler Richtung nebeneinander an der Oberseite angeordneten Anschlussflächen aufweist. In einem nächsten Schritt wird eine Mehrzahl von in lateraler Richtung beabstandet zueinander angeordneten optoelektronischen Bauelementen an der Oberseite des Trägers angeordnet, wobei die optoelektronischen Bauelemente jeweils zumindest eine dem Träger abgewandte Kontaktfläche aufweisen. In einem nächsten Schritt werden Schutzelemente auf die Kontaktflächen und die Anschlussflächen aufgebracht. In einem weiteren Schritt wird zumindest eine elektrisch isolierende Schicht auf freiliegende Stellen des Trägers, der Kontaktflächen sowie der Schutzelemente aufgebracht. Weiter werden in einem nächsten Schritt die Schutzelemente entfernt, wodurch Öffnungen in der elektrisch isolierenden Schicht erzeugt werden. In einem nächsten Schritt wird elektrisch leitfähiges Material auf der elektrisch isolierenden Schicht und zumindest stellenweise in den Öffnungen angeordnet, wobei das elektrisch leitfähige Material jeweils eine Kontaktfläche mit der ihr zugeordneten Anschlussfläche elektrisch leitend verbindet.

Das hier beschriebene Verfahren zur Herstellung eines optoelektronischen Halbleiterbauelements beruht dabei unter anderem auf der Erkenntnis, dass die Herstellung eines optoelektronischen Halbleiterbauelements, welches durch eine elektrisch isolierende Schicht hindurch kontaktiert wird, kostenintensiv sein kann. Um beispielsweise von der elektrisch isolierenden Schicht bedeckte Kontakte des optoelektronischen Bauelements freizulegen, kann an diesen Stellen die elektrisch isolierende Schicht mittels Materialabtrags, zum Beispiel durch Bohren, entfernt werden. Nach dem Materialabtrag liegen die Kontaktflächen frei und können von außen elektrisch kontaktiert werden. Eine solche nachträgliche Freilegung der Kontaktflächen kann jedoch kostenintensiv und zeitaufwändig sein. Ferner kann durch einen derartigen Materialabtrag die Kontaktfläche des optoelektronischen Bauelements geschädigt werden.

Um nun ein Verfahren zur Herstellung zumindest eines optoelektronischen Halbleiterbauelements anzugeben, welches kostengünstig und wenig zeitaufwändig ist, macht das hier beschriebene Verfahren unter anderem von der Idee Gebrauch, vor dem Aufbringen einer der elektrisch isolierenden Schicht auf das optoelektronische Bauelement Schutzelemente auf den jeweiligen Kontakten des optoelektronischen Bauelements anzuordnen. Mit anderen Worten sind die Kontakte von den Schutzelementen zumindest stellenweise abgedeckt. Wird nun in einem nächsten Schritt die elektrisch isolierende Schicht auf freiliegende Stellen des optoelektronischen aufgebracht, sind die Kontaktflächen zumindest stellenweise mit der elektrisch isolierenden Schicht nicht in direktem Kontakt. In einem nächsten Schritt kann dann das Schutzelement von der Kontaktfläche entfernt werden. Nach dem Entfernen des Schutzelements ist eine Öffnung in der elektrisch isolierenden Schicht eingebracht, wodurch die Kontaktflächen zumindest stellenweise freiliegen und über die Öffnungen von außen kontaktiert werden können. Mit anderen Worten ersetzt das Schutzelement einen Materialabtrag über den Kontaktflächen in der elektrisch isolierenden Schicht. Ein derartiges Verfahren ist nicht nur kostengünstig und weniger zeitaufwändig, sondern auch besonders materialschonend für die Kontaktflächen, da die elektrisch isolierende Schicht nicht mehr zur Freilegung der Kontaktflächen entfernt werden muss. Ebenso erspart das hier beschriebene Verfahren einen aufwendigen Nachreinigungsprozess zum Beispiel in den Öffnungen der elektrisch isolierenden Schicht. Ferner ist das Verfahren flexibel im Fertigungsablauf, da beispielsweise die Schutzelemente schrittweise aufgebracht werden können. Vorteilhaft werden bei vorliegendem Verfahren die Kontaktflächen nicht durch beispielsweise hochenergetisches Laserlicht geschädigt. Durch das Vermeiden von Oberflächenschäden an den Kontaktflächen können die Kontaktflächen zuverlässiger ankontaktiert werden, wodurch eine optische Ausgangsleistung des späteren Halbleiterbauelements erhöht wird.

Gemäß zumindest einer Ausführungsform ist die elektrisch isolierende Schicht strahlungsreflektierend oder strahlungsabsorbierend. "Strahlungsreflektierend" heißt insbesondere, dass die elektrisch isolierende Schicht zumindest zu 80 %, bevorzugt zu mehr als 90 % reflektierend für auf sie auftreffendes Licht ist. Beispielsweise erscheint für einen externen Betrachter die elektrisch isolierende Schicht weiß. Beispielsweise sind dazu in die elektrisch isolierende Schicht strahlungsreflektierende Partikel eingebracht, die zum Beispiel mit zumindest einem der Materialien TiO₂, BaSo₄, ZnO oder AlₓO_{y} gebildet sind oder eines der genannten Materialien enthalten. Bei einer strahlungsabsorbierenden elektrisch isolierenden Schicht kann die elektrisch isolierende Schicht für einen externen Betrachter schwarz oder farbig erscheinen. Zum Beispiel sind dann in die elektrisch isolierende Schicht Rußpartikel eingebracht.

Gemäß zumindest einer Ausführungsform ist die elektrisch isolierende Schicht ein Verguss, der durch Vergießen aufgebracht ist. Beispielsweise wird dazu die elektrisch isolierende Schicht auf freiliegende Stellen des Trägers der Kontaktflächen sowie der Schutzelemente mittels Vergießens und anschließendem Aushärten aufgebracht.

Gemäß zumindest einer Ausführungsform ist zumindest eines der Schutzelemente mit zumindest einem der Materialien Halbleitermaterial, keramisches Material, Kunststoffmaterial gebildet oder enthält zumindest eines der Materialien.

Gemäß zumindest einer Ausführungsform sind die Schutzelemente mittels zumindest einem der Prozesse Jetten, Laminieren, Dispensen, Siebdruck, Spritzen aufgebracht. Beispielsweise wird beim Jetten die elektrisch isolierende Schicht aufgedruckt. Beim Dispensen ist denkbar, dass die elektrisch isolierende Schicht in Form von Tröpfen beispielsweise mittels eines Pipetteninstruments aufgebracht wird.

Gemäß zumindest einer Ausführungsform verringert sich eine laterale Ausdehnung zumindest eines der Schutzelemente ausgehend von einer dem Träger abgewandten Seite der Schutzelemente in Richtung der Unterseite des Trägers. "Laterale Ausdehnung" bezeichnet den maximalen Abstand zweier Punkte des jeweiligen Schutzelements, die in lateraler Richtung in derselben Ebene liegen. Ist das Schutzelement in einer Draufsicht zum Beispiel kreisförmig, so handelt es sich bei der lateralen Ausdehnung um den Durchmesser. Beispielsweise ist zumindest eines der Schutzelemente in einer seitlichen Ansicht kegelförmig. Zumindest eines der Schutzelemente verjüngt sich dann ausgehend von der dem Träger abgewandten Seite des Schutzelements in Richtung der Unterseite des Trägers.

Gemäß zumindest einer Ausführungsform des Verfahrens werden vor dem Schritt d) Schutzelemente an der Oberseite des Trägers am Träger entlang von Trennungslinien aufgebracht. Auch hierbei werden nach dem Entfernen der Schutzelemente im Bereich der Trennungslinien weitere Öffnungen erzeugt.

Gemäß zumindest einer Ausführungsform des Verfahrens wird der Träger nach dem Entfernen der Schutzelemente in einzelne optoelektronische Halbleiterbauelemente entlang der Trennungslinien vereinzelt. Da im Bereich der Trennungslinien die elektrisch isolierende Schicht entfernt ist, muss lediglich nur noch durch den Träger vereinzelt werden. Dadurch kann auf aufwändige und wenig materialschonende Trennungsprozesse verzichtet werden. Mit anderen Worten kann auf zeitraubende und aufwändige Prozesse zur Vereinzelung verzichtet werden. Dies führt zu einer Kostenersparnis und einer schnelleren Fertigung der optoelektronischen Halbleiterbauelemente.

Gemäß zumindest einer Ausführungsform schließen die Schutzelemente bündig mit der elektrisch isolierenden Schicht in vertikaler Richtung ab. Das heißt, dass sich zwischen den Schutzelementen und der elektrisch isolierenden Schicht in lateraler Richtung weder ein Spalt noch eine Unterbrechung ausbildet. Beispielsweise bilden die Schutzelemente und die elektrisch isolierende Schicht zusammen eine durchgehende und zusammenhängende Ebene aus. Vorzugsweise sind die Schutzelemente von außen einsehbar.

Gemäß zumindest einer Ausführungsform wird vor dem Schritt d) zumindest ein Konversionselement auf eine Strahlungsdurchtrittsfläche eines optoelektronischen Bauelements aufgebracht. Über die Strahlungsdurchtrittsfläche wird beispielsweise innerhalb eines optoelektronischen Bauelements erzeugte elektromagnetische Strahlung aus dem optoelektronischen Bauelement ausgekoppelt oder von dem optoelektronischen Bauelement durch die Strahlungsdurchtrittsfläche hindurch in das optoelektronische Bauelement eintretende elektromagnetische Strahlung detektiert. Das Konversionselement dient zur zumindest teilweisen Konversion von primär innerhalb des optoelektronischen Bauelements erzeugter elektromagnetischer Strahlung in elektromagnetische Strahlung anderer Wellenlänge. Beispielsweise ist das Konversionselement auf die Strahlungsdurchtrittsfläche aufgeklebt.

Gemäß zumindest einer Ausführungsform des Verfahrens wird vor dem Schritt d) eine Schutzschicht auf eine Strahlungsdurchtrittsfläche eines optoelektronischen Bauelements aufgebracht, welche die Strahlungsdurchtrittsfläche zumindest stellenweise bedeckt, wobei die Schutzschicht nach dem Schritt d) entfernt wird, wodurch ein Fenster in der elektrisch isolierenden Schicht erzeugt wird. Die Schutzschicht wird beispielsweise direkt auf die Strahlungsdurchtrittsfläche eines optoelektronischen Bauelements aufgebracht und bedeckt diese zumindest stellenweise. An Stellen, an denen die Schutzschicht auf die Strahlungsdurchtrittsfläche aufgebracht ist, ist nach dem Schritt d) die elektrisch isolierende Schicht nicht in direktem Kontakt mit dem optoelektronischen Bauelement. Mit anderen Worten ist an diesen Stellen die Schutzschicht zwischen der Strahlungsdurchtrittsfläche und der elektrisch isolierenden Schicht angeordnet. Nach dem Aufbringen der elektrisch isolierenden Schicht kann die elektrisch isolierende Schicht von der Schutzschicht, beispielsweise mittels hochenergetischem Laserlichts, wieder von der Schutzschicht entfernt werden. Anschließend kann auch die Schutzschicht von der Strahlungsdurchtrittsfläche des optoelektronischen Bauelements entfernt werden. Das Entfernen der Schutzschicht kann mittels Ätzen der Schutzschicht, beispielsweise unter Verwendung von Kaliumhydroxid (auch KOH), erfolgen. Beispielsweise ist das nach dem Entfernen der Schutzschicht erzeugte Fenster in der elektrisch isolierenden Schicht durch zumindest eine Seitenfläche, eine Bodenfläche und eine der Bodenfläche gegenüberliegende Deckfläche gebildet. Zum Beispiel ist die Seitenfläche vollständig durch die elektrisch isolierende Schicht gebildet, wobei die Bodenfläche zum Beispiel vollständig durch das optoelektronische Bauelement gebildet sein kann. Denkbar ist, dass die Schutzschicht mit dem gleichen Material wie die Schutzelemente gebildet ist. "Gleiches Material" heißt in diesem Zusammenhang, dass die Materialien der Schutzschicht und das Material der Schutzelemente identisch sind. Ebenso kann die Schutzschicht mit dem gleichen Verfahren wie die Schutzelemente aufgebracht sein.

Gemäß zumindest einer Ausführungsform des Verfahrens wird in dem Fenster zumindest ein Konversionselement und/oder ein weiterer Verguss angeordnet, wobei der weitere Verguss zumindest ein Lumineszenzkonversionsmaterial enthält. Das Lumineszenzkonversionsmaterial dient zur zumindest teilweisen Konversion von primär innerhalb des optoelektronischen Bauelements erzeugter elektromagnetischer Strahlung in elektromagnetische Strahlung anderer Wellenlänge.

Es wird darüber hinaus noch ein optoelektronisches Halbleiterbauelement angegeben.

Beispielsweise kann das optoelektronische Halbleiterbauelement mittels des hier beschriebenen Verfahrens hergestellt werden, wie es in Verbindung mit einem oder mehreren der oben genannten Ausführungsformen beschrieben ist. Das heißt, die für das hier beschriebene Verfahren ausgeführten Merkmale sind auch für das hier beschriebene optoelektronische Halbleiterbauelement offenbart und umgekehrt.

Gemäß zumindest einer Ausführungsform umfasst das optoelektronische Halbleiterbauelement einen Träger, der eine Oberseite, eine der Oberseite des Trägers gegenüberliegende Unterseite, sowie zumindest eine an der Oberseite angeordnete Anschlussfläche aufweist.

Gemäß zumindest einer Ausführungsform umfasst das optoelektronische Halbleiterbauelement zumindest ein an der Oberseite des Trägers angeordnetes optoelektronisches Bauelement, das zumindest eine den Träger abgewandte Kontaktfläche aufweist.

Gemäß zumindest einer Ausführungsform umfasst das optoelektronische Halbleiterbauelement zumindest eine elektrisch isolierende Schicht, welche auf freiliegende Stellen des Trägers und des optoelektronischen Bauelements aufgebracht ist. Beispielsweise bedeckt die elektrisch isolierende Schicht alle freiliegenden Stellen des optoelektronischen Bauelements formschlüssig.

Gemäß zumindest einer Ausführungsform umfasst das optoelektronische Halbleiterbauelement zumindest zwei über der Anschlussfläche und der Kontaktfläche in lateraler Richtung beabstandet zueinander angeordnete Öffnungen in der elektrisch isolierenden Schicht. Das heißt, dass in vertikaler Richtung die Anschlussfläche und die Kontaktfläche zumindest stellenweise mit den Öffnungen überlappen und an diesen Stellen von der elektrisch isolierenden Schicht befreit sind.

Gemäß zumindest einer Ausführungsform umfasst das optoelektronische Halbleiterbauelement elektrisch leitfähiges Material, welches auf der elektrisch isolierenden Schicht und zumindest stellenweise in den Öffnungen angeordnet ist.

Gemäß zumindest einer Ausführungsform verringert sich eine laterale Ausdehnung zumindest einer der Öffnungen ausgehend von einer dem Träger abgewandeten Seite der elektrisch isolierenden Schicht in Richtung der Unterseite des Trägers. In einer seitlichen Ansicht können die Öffnungen kegelförmig sein. Insbesondere sind die Öffnungen nicht mittels eines Materialabtrags in der elektrisch isolierenden Schicht erzeugt. Beispielsweise weisen die Öffnungen, die Kontaktfläche und die Anschlussfläche keine mechanischen Oberflächenschädigungen auf. Insbesondere weisen die Seitenflächen der Öffnungen, beispielsweise zusätzlich auch Außenflächen der Kontaktfläche und der Anschlussfläche, keine Spuren eines Materialabtrags, zum Beispiel in Form von thermischen Oberflächenschädigungen, auf. Das heißt, dass die Seitenflächen und die Außenflächen dann nicht mittels hochenergetischem Laserlicht bearbeitet und/oder beschädigt sind. Mit anderen Worten können die Öffnungen mittels der hier beschriebenen Schutzelemente erzeugt sein, welche von der elektrisch isolierenden Schicht entfernt sind.

Gemäß zumindest einer Ausführungsform verbindet das elektrisch leitfähige Material jeweils die Kontaktfläche mit der Anschlussfläche elektrisch leitend.

Im Folgenden werden das hier beschriebene Verfahren sowie ein hier beschriebenes optoelektronisches Halbleiterbauelement anhand von Ausführungsbeispielen und den dazugehörigen Figuren näher erläutert.
- Die Figuren 1 und 2: zeigen einzelne Fertigungsschritte zur Herstellung zweier Ausführungsbeispiele durch ein hier beschriebenes Verfahren.
- Die Figur 3: zeigt in einer schematischen Seitenansicht ein Ausführungsbeispiel eines hier beschriebenen optoelektronischen Halbleiterbauelements.

In den Ausführungsbeispielen und den Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

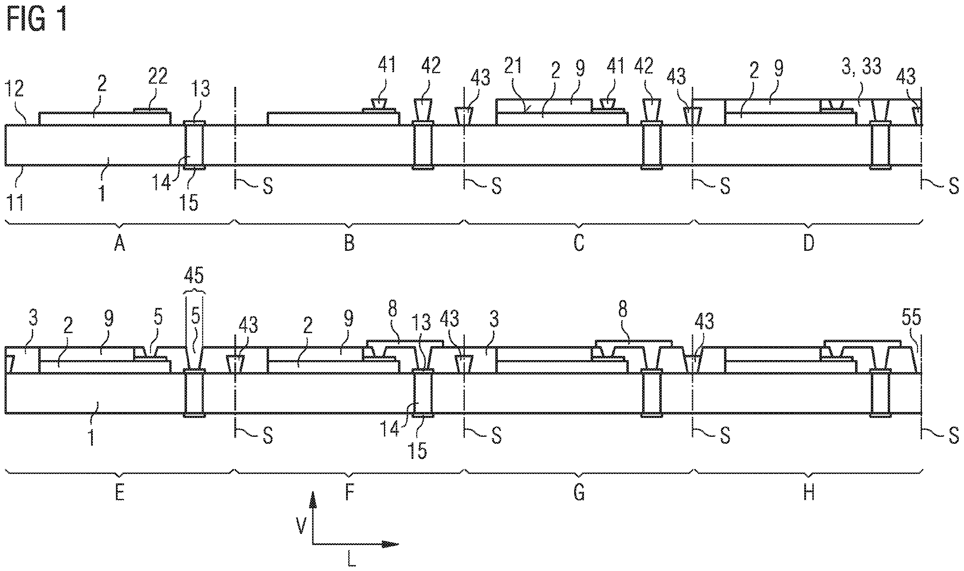

Die Figur 1 zeigt in Abschnitt A Schritte a) und b), bei dem zunächst ein Träger 1, welcher eine Oberseite 12 und eine der Oberseite 12 des Trägers 1 gegenüberliegende Unterseite 11 aufweist, bereitgestellt wird. Ferner weist der Träger 1 eine Mehrzahl von in lateraler Richtung L nebeneinander an der Oberseite 12 angeordnete Anschlussflächen 13 auf. Auf dem Träger 1 sind die optoelektronischen Bauelemente 2 angeordnet. Jedes der optoelektronischen Bauelemente 2 weist ein dem Träger 1 abgewandte Kontaktfläche 22 auf. Bei den optoelektronischen Bauelementen 2 kann es sich um strahlungsemittierende Halbleiterchips handeln, die ultraviolette Strahlung oder sichtbares Licht emittieren.

In den Abschnitten A bis H der Figur 1 ist dargestellt, dass die Anschlussflächen 13 jeweils durch eine Durchkontaktierung 14 gebildet sind. Die Durchkontaktierung 14 erstreckt sich ausgehend von Oberseite 12 des Trägers 1 in Richtung der Unterseite 11 des Trägers 1 vollständig durch den Träger 1 hindurch. An der Unterseite 11 bildet die Durchkontaktierung 14 jeweils eine weitere Anschlussfläche 15 aus. Beispielsweise ist mit einer derartigen weiteren Anschlussfläche 15 ein späteres optoelektronisches Halbleiterbauelement 100 oberflächenmontierbar.

In Abschnitt B der Figur 1 ist in einem Schritt c) gezeigt, wie auf die Kontaktflächen 22 der optoelektronischen Bauelemente 2 und die Anschlussflächen 13 jeweils Schutzelemente 41 und 42 aufgebracht werden. Vorliegend werden die Schutzelemente 41 und 42 mittels Jetten aufgebracht. Ferner ist aus dem Abschnitt B der Figur 1 erkennbar, dass zusätzlich entlang von Trennungslinien S Schutzelemente 43 aufgebracht werden. Dabei können die Schutzelemente 41, 42 und/oder 43 mit einem Fotolack und/oder einem Heißkleber gebildet sein.

In Abschnitt C der Figur 1 ist dargestellt, wie auf eine Strahlungsdurchtrittsfläche 21 der optoelektronischen Bauelemente 2 eine Konversionselement 9 aufgebracht wird. Das Konversionselement 9 ist vorliegend in Form einer Schicht ausgebildet und bedeckt zumindest stellenweise die Strahlungsdurchtrittsfläche 21 des optoelektronischen Bauelements 2. Beispielsweise wandelt das Konversionselement 9 von optoelektronischem Bauelement 2 emittiertes blaues Licht teilweise in gelbes Licht um, das sich dann zusammen mit dem blauen Licht zu weißem Licht vermischen kann.

Wie im Abschnitt D der Figur 1 dargestellt, wird in einem nächsten Schritt d) eine elektrisch isolierende Schicht 3 auf freiliegende Stellen der Schutzelemente 41, 42 und 43, der optoelektronischen Bauelemente 2, der Konversionselemente 9 sowie freiliegenden Stellen des Trägers 1 mittels Vergießens aufgebracht. Mit anderen Worten ist die elektrisch isolierende Schicht 3 ein Verguss 33, der durch Vergießen aufgebracht ist. Vorliegend schließen in vertikaler Richtung V die Schutzelemente 41 und 42 sowie die Konversionselemente 9 bündig mit der elektrisch isolierenden Schicht 3 ab. Das Schutzelement 43 ist hingegen vollständig und formschlüssig an freiliegenden Stellen von elektrisch isolierender Schicht 3 bedeckt. In einer Draufsicht auf den Träger 1 sind die Schutzelemente 41 und 42 von außen einsehbar und beispielsweise frei zugänglich.

In Abschnitt E der Figur 1 ist ein Schritt e) dargestellt, bei dem die Schutzelemente 41 und 42 wieder entfernt werden. Vorliegend verringert sich eine laterale Ausdehnung 45 der Schutzelemente 41 ausgehend von einer dem Träger 1 abgewandten Seite der Schutzelemente 41 und 42 in Richtung Unterseite 11 des Trägers 1. Mit anderen Worten sind die Schutzelemente 41 und 42 kegelförmig ausgebildet. Durch eine derartige kegelförmige Ausbildung der Schutzelemente 41 und 42 können die Schutzelemente 41 und 42 besonders einfach und kostengünstig wieder entfernt werden. Beispielsweise kann das Entfernen der Schutzelemente 41 und 42 mittels wässrigem Strippen, das heißt mittels nasschemischen Ätzens, der Schutzelemente 41 und 42 geschehen.

In Abschnitt F der Figur 1 ist dargestellt, wie in einem nächsten Schritt f) elektrisch leitfähiges Material 8 auf der elektrisch isolierenden Schicht 3 und in durch das Entfernen der Schutzelemente 41, 42 in der elektrisch isolierenden Schicht 3 erzeugten Öffnungen 5 angeordnet wird. Aufgrund der kegelförmigen Form der Schutzelemente 41 und 42 sind ebenso die Öffnungen 5 kegelförmig. Die Öffnungen 5 sind also nicht mittels eines Materialabtrags in der elektrisch isolierenden Schicht, wie zum Beispiel Bohren, erzeugt.

Das elektrisch leitfähige Material 8 ist vollständig in den Öffnungen 5 sowie in lateraler Richtung L zwischen den beiden Öffnungen 5 auf einer dem Träger 1 abgewandten Außenfläche der elektrisch isolierenden Schicht 3 angeordnet. Durch die kegelförmige Ausgestaltung der Öffnungen 5 können diese besonders einfach mit dem elektrisch leitfähigen Material 8 befüllt werden. Beispielsweise geschieht das Aufbringen des elektrisch leitfähigen Materials 8 mittels Sputtern und/oder Jetten. Beispielsweise ist das elektrisch leitfähige Material 8 mit Ti und/oder Cu gebildet. Das elektrisch leitfähige Material 8 steht mit den jeweiligen Kontaktflächen 22 der optoelektronischen Bauelemente 2 sowie mit den Anschlussflächen 13 in direktem Kontakt. Mit anderen Worten ist vorliegend jedes der optoelektronischen Bauelemente 2 durch das elektrisch leitfähige Material 8 über die Anschlussstelle 13 und über die Durchkontaktierung 14 mit der weiteren Anschlussstelle 15 elektrisch leitend kontaktiert.

In Abschnitt G der Figur 1 ist weiter dargestellt, wie die elektrisch isolierende Schicht 3 im Bereich des Schutzelements 43 über dem Schutzelement 43 entfernt wird. Beispielsweise geschieht das Entfernen mittels hochenergetischem Laserlicht.

Weiter ist in einem nächsten Schritt in Abschnitt H der Figur 1 dargestellt, wie das Schutzelement 43 entfernt wird, wodurch eine weitere Öffnung 55 in der elektrisch isolierenden Schicht 3 erzeugt ist. Vorteilhaft muss während des Vereinzelns in einzelne optoelektronische Halbleiterbauelemente 100 nicht durch die elektrisch isolierende Schicht 3, sondern lediglich durch den Träger 1 entlang der Trennungslinie S vereinzelt werden.

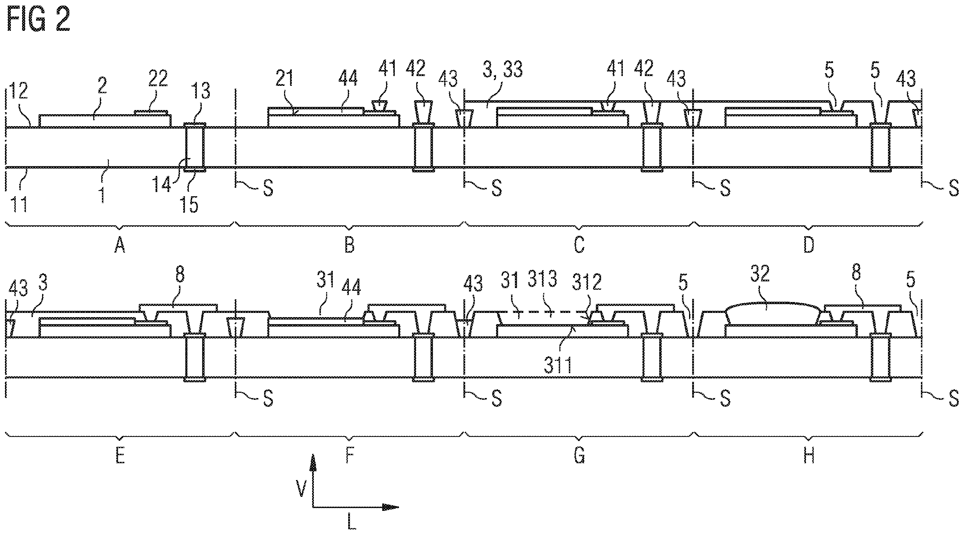

In der Figur 2 sind einzelne Fertigungsschritte zur Herstellung eines weiteren Ausführungsbeispiels durch ein hier beschriebenes Verfahren beschrieben.

Im Unterschied zu dem in der Figur 1 dargestellten Verfahren wird bei dem in der Figur 2 dargestellten Verfahren auf das Aufbringen eines Konversionselements 9 verzichtet. Stattdessen wird in Abschnitt B der Figur 2 auf eine Strahlungsdurchtrittsfläche 21 jedes der optoelektronischen Bauelemente 2 eine Schutzschicht 44 aufgebracht. Mit anderen Worten bedeckt die Schutzschicht 44 die Strahlungsdurchtrittsfläche 21 der optoelektronischen Bauelemente 2 zumindest stellenweise.

In Abschnitt C der Figur 2 ist erkennbar, dass die Schutzschicht 44 von der elektrisch isolierenden Schicht 3 an allen freiliegenden Stellen vollständig und formschlüssig bedeckt ist.

In den Abschnitten D und E der Figur 2 ist wiederum der Schritt e) dargestellt, wie durch Entfernen der Schutzelemente 41 und 42 Öffnungen 5 erzeugt werden und in diesen Öffnungen 5 anschließend elektrisch leitfähiges Material 8, wie in den Ausführungen zu der Figur 1 beschrieben, angeordnet wird.

In Abschnitt F der Figur 2 ist dargestellt, wie die elektrisch isolierende Schicht 3 von der Schutzschicht 44 entfernt wird. Mit anderen Worten ist die Schutzschicht 44 dann zumindest stellenweise frei von der elektrisch isolierenden Schicht 3. "Frei" heißt in diesem Zusammenhang, dass die Schutzschicht 44 von der elektrisch isolierenden Schicht 3 nicht mehr bedeckt ist. Es ist höchstens möglich, dass herstellungsbedingt sich noch Materialreste der elektrisch isolierenden Schicht 3 auf der Schutzschicht 44 an den befreiten Stellen befinden.

In einem in Abschnitt G der Figur 2 dargestellten nächsten Schritt wird die Schutzschicht 44 von der Strahlungsdurchtrittsfläche 21 entfernt. Durch das Entfernen ist ein Fenster 31 in der elektrisch isolierenden Schicht 3 erzeugt, welches vorliegend eine Bodenfläche 311, eine der Bodenfläche 311 gegenüberliegende Öffnung 313 sowie Seitenflächen 312 aufweist. Die Seitenflächen 312 sind vollständig durch die elektrisch isolierende Schicht 3 gebildet, wobei die Bodenfläche 311 des Fensters 31 vollständig durch die Strahlungsdurchtrittsfläche 21 gebildet ist.

In Abschnitt H der Figur 2 ist weiter dargestellt, dass in das Fenster 31 ein weiterer Verguss 32 angeordnet wird, der ein Lumineszenzkonversionsmaterial enthält. Vorliegend handelt es sich bei dem Lumineszenzkonversionsmaterial um Phosphor, welches in das Material des weiteren Vergusses 32 eingebracht ist. Zum Beispiel sind die optoelektronischen Bauelemente 2 RGB-Leuchtdiodenchips, deren emittiertes weißes Licht teilweise in Licht anderer Wellenlänge umgewandelt wird.

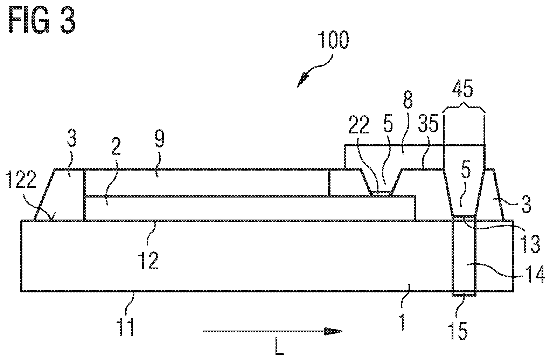

In der Figur 3 ist in einer seitlichen Ansicht ein hier beschriebenes optoelektronisches Bauelement 100 dargestellt. Das optoelektronische Bauelement 100 weist den Träger 1 mit der Oberseite 12 sowie einer der Oberseite 12 gegenüberliegenden Unterseite 11 auf. Auf einer an der Oberseite 12 ausgebildeten Montagefläche 122 ist ein optoelektronisches Bauelement 2 angebracht und mit dem Träger 1 elektrisch leitend kontaktiert. In Öffnungen 5 in der elektrisch isolierenden Schicht 3 ist das elektrisch leitfähige Material 8 angeordnet und füllt die Öffnungen 5 vollständig aus. Ferner erstreckt sich das elektrisch leitfähige Material 8 entlang einer Oberseite 35 der elektrisch isolierenden Schicht 3 in lateraler Richtung L zwischen den beiden Öffnungen 5. Das elektrisch leitfähige Material 8 bildet eine durchgehende elektrisch leitende Verbindung zwischen der Anschlussfläche 13 und der Kontaktfläche 22. Insbesondere sind die Öffnungen nicht mittels Materialabtrags in der elektrisch isolierenden Schicht 3 erzeugt. Das heißt, dass die Öffnungen 5, die Kontaktfläche 22 und die Anschlussfläche 13 keine durch Bohren verursachten Oberflächenschäden aufweist.
Die Erfindung ist nicht durch die Beschreibung anhand der Ausführungsbeispiele beschränkt.

Diese Patentanmeldung beansprucht die Priorität der deutschen Patentanmeldung 10 2010 034 565.

## Patentansprüche

1. Verfahren zur Herstellung zumindest eines optoelektronischen Halbleiterbauelements (100), mit den folgenden Schritten:
a) Bereitstellen eines Trägers (1), der eine Oberseite (12), eine der Oberseite (12) des Trägers (1) gegenüberliegende Unterseite (11), sowie eine Mehrzahl von in lateraler Richtung (L) nebeneinander an der Oberseite (12) angeordneten Anschlussflächen (13) aufweist;
b) Aufbringen einer Mehrzahl von in lateraler Richtung (L) beabstandet zueinander angeordneten optoelektronischen Bauelementen (2) an der Oberseite (12) des Trägers (1), die jeweils zumindest eine dem Träger (1) abgewandte Kontaktfläche (22) aufweisen;
c) Aufbringen von Schutzelementen (41, 42) auf die Kontaktflächen (22) und die Anschlussflächen (13); Aufbringen von Schutzelementen (43) an der Oberseite (12) des Trägers (1) am Träger (1) entlang von Trennungslinien (S);
d) Aufbringen zumindest einer elektrisch isolierenden Schicht (3) auf freiliegende Stellen des Trägers (1), der Kontaktflächen (22) sowie der Schutzelemente (4);
e) Entfernen der Schutzelemente (41, 42, 43), wodurch Öffnungen (51, 52) in der elektrisch isolierenden Schicht (3) erzeugt werden;
Vereinzeln des Trägers (1) in einzelne optoelektronische Halbleiterbauelemente (100) entlang der Trennungslinien (S);
f) Anordnen von elektrisch leitfähigem Material (8) auf der elektrisch isolierenden Schicht (3) und zumindest stellenweise in den Öffnungen (5), wobei das elektrisch leitfähige Material (8) jeweils eine Kontaktfläche (22) mit der ihr zugeordneten Anschlussfläche (13) elektrisch leitend verbindet.

2. Verfahren nach Anspruch 1,
bei dem die elektrisch isolierende Schicht (3) strahlungsreflektierend oder strahlungsabsorbierend ist.

3. Verfahren nach einem der vorhergehenden Ansprüche,
bei dem die elektrisch isolierende Schicht (3) ein Verguss (33) ist, der durch Vergießen aufgebracht ist.

4. Verfahren nach einem der vorhergehenden Ansprüche,
bei dem zumindest eines der Schutzelemente (41, 42) mit zumindest einem der folgenden Materialien gebildet ist oder zumindest eines der Materialien enthält: Halbeitermaterial, keramisches Material, Kunststoffmaterial.

5. Verfahren nach einem der vorhergehenden Ansprüche,
bei dem zumindest eines der Schutzelemente (41, 42) mittels zumindest einem der Prozesse aufgebracht ist: Jetten, Laminieren, Dispensen, Siebdruck, Spritzen.

6. Verfahren nach einem der vorhergehenden Ansprüche,
bei dem eine laterale Ausdehnung (44) zumindest eines der Schutzelemente (41, 42) sich ausgehend von einer dem Träger (1) abgewandeten Seite der Schutzelemente (41, 42) in Richtung der Unterseite (11) des Trägers (1) verringert.

7. Verfahren nach einem der vorhergehenden Ansprüche,
bei dem in vertikaler Richtung (V) die Schutzelemente (41, 42) bündig mit der elektrisch isolierenden Schicht (3) abschließen.

8. Verfahren nach einem der vorhergehenden Ansprüche,
bei dem vor dem Schritt d) zumindest ein Konversionselement (9) auf eine Strahlungsdurchtrittsfläche (21) eines optoelektronischen Bauelements (2) aufgebracht wird.

9. Verfahren nach einem der vorhergehenden Ansprüche 1 bis 7,
bei dem vor dem Schritt d) eine Schutzschicht (44) auf eine Strahlungsdurchtrittsfläche (21) eines optoelektronischen Bauelements (2) aufgebracht wird, welche die Strahlungsdurchtrittsfläche (2) zumindest stellenweise bedeckt, wobei die Schutzschicht (44) nach dem Schritt d) entfernt wird, wodurch ein Fenster (31) in der elektrisch isolierenden Schicht (3) erzeugt wird.

10. Verfahren nach dem vorhergehenden Anspruch,
bei dem in dem Fenster (31) zumindest ein Konversionselement (9) und/oder ein weiterer Verguss (32) angeordnet wird, wobei der weitere Verguss (32) zumindest ein Lumineszenzkonversionsmaterial (51) enthält.

## Claims

1. A method for producing at least one optoelectronic semiconductor component (100), comprising the following steps:
a) providing a carrier (1) having a top side (12), an underside (11) situated opposite the top side (12) of the carrier (1), and a plurality of connection areas (13) arranged at the top side (12) alongside one another in a lateral direction (L);
b) applying a plurality of optoelectronic components (2) arranged at a distance from one another in a lateral direction (L) at the top side (12) of the carrier (1), said components each having at least one contact area (22) facing away from the carrier (1);
c) applying protective elements (41, 42) to the contact areas (22) and the connection areas (13);
applying protective elements (43) at the top side (12) of the carrier (1) along separating lines (S);
d) applying at least one electrically insulating layer (3) to exposed locations of the carrier (1), of the contact areas (22) and of the protective elements (4);
e) removing the protective elements (41, 42, 43), as a result of which openings (51, 52) are produced in the electrically insulating layer (3);
singulating the carrier (1) is into individual optoelectronic semiconductor components (100) along the separating lines (S) ;
f) arranging electrically conductive material (8) on the electrically insulating layer (3) and at least in places in the openings (5), wherein the electrically conductive material (8) in each case electrically conductively connects a contact area (22) to the connection area (13) assigned thereto.

2. The method according to claim 1,
wherein the electrically insulating layer (3) is radiation-reflective or radiation-absorbent.

3. The method according to either of the preceding claims,
wherein the electrically insulating layer (3) is a potting (33) applied by a potting process.

4. The method according to any of the preceding claims,
wherein at least one of the protective elements (41, 42) is formed with at least one of the following materials or contains at least one of the following materials: semiconductor material, ceramic material, plastics material.

5. The method according to any of the preceding claims,
wherein at least one of the protective elements (41, 42) is applied by means of at least one of the following processes: jetting, laminating, dispensing, screen printing, injecting.

6. The method according to any of the preceding claims,
wherein a lateral extent (44) of at least one of the protective elements (41, 42) decreases, proceeding from a side of the protective elements (41, 42) which faces away from the carrier (1), in the direction of the underside (11) of the carrier (1).

7. The method according to any of the preceding claims,
wherein, in a vertical direction (V), the protective elements (41, 42) terminate flush with the electrically insulating layer (3).

8. The method according to any of the preceding claims,
wherein, before step d), at least one conversion element (9) is applied to a radiation passage area (21) of an optoelectronic component (2).

9. The method according to any of the preceding claims 1 to 7,
wherein, before step d), a protective layer (44) is applied to a radiation passage area (21) of an optoelectronic component (2), which covers the radiation passage area (2) at least in places, wherein the protective layer (44) is removed after step d), as a result of which a window (31) is produced in the electrically insulating layer (3).

10. The method according to the preceding claim,
wherein at least one conversion element (9) and/or a further potting (32) are/is arranged in the window (31), wherein the further potting (32) contains at least one luminescence conversion material (51).

## Revendications

1. Procédé destiné à la fabrication de tout au moins un composant optoélectronique semi-conducteur (100), comprenant les phases suivantes :
a) préparation d'un support (1) qui présente une face supérieure (12), une face inférieure (11) se trouvant à l'opposé de la face supérieure (12) du support (1), ainsi qu'une pluralité de surfaces de connexion (13) disposées les unes à côté des autres, dans la direction latérale (L), au niveau de la face supérieure (12) ;
b) mise en place d'une pluralité de composants (2) optoélectroniques disposés à distance les uns des autres, dans la direction latérale (L), au niveau de la face supérieure (12) du support (1), lesquels composants présentent respectivement tout au moins une surface de contact (22) opposée au support (1) ;
c) mise en place d'éléments de protection (41, 42) sur les surfaces de contact (22) et sur les surfaces de connexion (13) ; mise en place d'éléments de protection (43) au niveau de la face supérieure (12) du support (1), au niveau du support (1), le long des lignes de séparation (S) ;
d) mise en place de tout au moins une couche (3) électriquement isolante sur des emplacements libres du support (1), sur des surfaces de contact (22), ainsi que sur des éléments de protection (4) ;
e) élimination des éléments de protection (41, 42, 43), permettant ainsi de créer des ouvertures (51, 52) dans la couche (3) électriquement isolante ; mise en oeuvre de la séparation du support (1) dans les divers composants semi-conducteurs (100) optoélectroniques distincts, le long des lignes de séparation (S) ;
f) mise en place d'un matériau (8) électriquement conducteur sur la couche (3) électriquement isolante, ainsi que dans les ouvertures (5), tout au moins par endroits, où le matériau (8) électriquement conducteur relie respectivement, de manière électriquement conductrice, une surface de contact (22) à la surface de connexion (13) qui lui est associée.

2. Procédé selon la revendication 1, selon lequel la couche (3) électriquement isolante présente des propriétés qui réfléchissent le rayonnement ou qui absorbent le rayonnement.

3. Procédé selon l'une des revendications précédentes, selon lequel la couche (3) électriquement isolante est un enrobage (33) qui est appliqué par coulage.

4. Procédé selon l'une des revendications précédentes, selon lequel tout au moins l'un des éléments de protection (41, 42) est constitué de tout au moins l'un des matériaux suivants ou contient tout au moins l'un des matériaux suivants : un matériau semi-conducteur, un matériau en céramique et/ou un matériau en matière plastique.

5. Procédé selon l'une des revendications précédentes, selon lequel tout au moins l'un des éléments de protection (41, 42) est mis en oeuvre au moyen de tout au moins l'un des processus suivants : par jet, par pelliculage, par dispensation, par sérigraphie et/ou par pulvérisation.

6. Procédé selon l'une des revendications précédentes, selon lequel une dilatation (44) latérale de tout au moins l'un des éléments de protection (41, 42) se rétrécit en partant d'une face des éléments de protection (41, 42) étant opposée au support (1), dans la direction de la face inférieure (11) du support (1).

7. Procédé selon l'une des revendications précédentes, selon lequel les éléments de protection (41, 42) se terminent dans la direction verticale (V) en étant en affleurement avec la couche (3) électriquement isolante.

8. Procédé selon l'une des revendications précédentes, selon lequel tout au moins un élément de conversion (9) est mis en place, avant la phase d), sur une surface de passage du rayonnement (21) d'un composant (2) optoélectronique.

9. Procédé selon l'une des revendications précédentes 1 à 7, selon lequel une couche de protection (44) est mise en place, avant la phase d), sur une surface de passage du rayonnement (21) d'un composant (2) optoélectronique, laquelle couche de protection recouvre la surface de passage du rayonnement (2), tout au moins par endroits, dans lequel la couche de protection (44) est éliminée à l'issue de la phase d), permettant la création d'une fenêtre (31) dans la couche (3) électriquement isolante.

10. Procédé selon la revendication précédente, selon lequel tout au moins un élément de conversion (9) et/ou un autre enrobage (32) est disposé dans la fenêtre (31), où cet autre enrobage (32) contient tout au moins un matériau de conversion de la luminescence (51).
